# FASCICULE DE BREVET EUROPEEN

(11) **EP 1 876 459 B1**
(45) Date de publication et mention de la délivrance du brevet: **23.09.2009**
(21) Numéro de dépôt: 07366002.9
(22) Date de dépôt: 15.06.2007
(51) Int. Cl.: G01R 31/3185

(54) **Circuit électronique comprenant un mode de test sécurisé par insertion de données leurres dans la chaîne de test, procédé associé**
Elektronischer Schaltkreis, der einen mittels Eingabe von Lockdaten in die Testkette gesicherten Testmodus umfasst, und zugehöriges Verfahren
Electronic circuit comprising a test mode secured by including decoy data in the test chain, associated method

(30) Priorité: 07.07.2006 FR 0606193
(43) Date de publication de la demande: 09.01.2008
(73) Titulaire: STMICROELECTRONICS SA, 92120 Montrouge (FR)
(72) Inventeur: Bancel, Frédéric, Novograaf Technologies, Metz Technopôle, 57070 Metz (FR); Hely, David, Novograaf Technologies, Metz Technopôle, 57070 Metz (FR)
(74) Mandataire: Brungard, Yves Francois

(56) Documents cités:
- EP-A- 1 560 033
- US-A1- 2003 204 801
- HELY D ET AL: "Test Control for Secure Scan Designs" TEST SYMPOSIUM, 2005. EUROPEAN TALLINN, ESTONIA 22-25 MAY 2005, PISCATAWAY, NJ, USA,IEEE, 22 mai 2005 (2005-05-22), pages 190-195, XP010801332 ISBN: 0-7695-2341-2

## Description

L'invention concerne, de façon générale, les circuits électroniques intégrés synchrones munis de moyens de logique combinatoire, de bascules, et de moyens de test. Plus précisément, l'invention concerne un circuit électronique comprenant des cellules configurables comprenant chacune une entrée de test et une sortie, les cellules configurables étant susceptibles d'être connectées entre elles en chaîne dans un ordre prédéfini par l'intermédiaire de leur entrée de test et de leur sortie pour former un registre de test si elles reçoivent un signal de commande de chaînage SCAN_ENABLE indiquant un mode de test du circuit électronique.
Les cellules configurables comprennent par ailleurs une entrée fonctionnelle et, lorsqu'elles ne reçoivent pas le signal de commande de chaînage, les cellules configurables sont connectées par l'intermédiaire de leur entrée fonctionnelle et de leur sortie à des cellules logiques avec lesquelles elles coopèrent pour former un ou plusieurs circuits logiques du circuit électronique (mode de fonctionnement standard du circuit électronique).

Il est aujourd'hui bien connu de vérifier le fonctionnement correct des éléments fonctionnels d'un circuit intégré en imposant et / ou en déterminant, à des instants prédéfinis, des valeurs de données présentes en certains points internes de ce circuit intégré. Une telle technique de test des chemins internes d'un circuit intégré (désignée par "scanpath" ou "internal scan method" en langue anglaise) est par exemple décrite dans la publication de M. Williams et J. Angel, intitulée "Enhancing Testability of LSI Circuits Via Test Points and Additional Logic, IEEE Transactions on Computers, vol. C-22, no.1; Janvier 1973". Cette technique, ses avantages et ses inconvénients sont également détaillés dans le document D1 (demande EP 1 560 033 du Demandeur), notamment aux paragraphes 2 à 16 incorporés par référence dans la présente demande.

Dans la demande US2003/0204801 (Tkacik et al., 30.10.2003) les cellules sont initialisées ou leur contenu est modifié à un signal ou des signaux appropriés. Le contenu des cellules est modifiable aléatoirement ou autrement pour garantir qu'aucune donnée sensible ne peut être extrait des cellules.

Outre la technique de test des chemins internes, D1 décrit également (invention de D1), un circuit électronique protégé d'une fraude visant à extraire des données des cellules configurables. Pour cela, dans D1, lorsqu'un changement de mode de fonctionnement est souhaité, on prévoit d'initialiser les cellules configurables et de vérifier leur initialisation correcte avant d'autoriser ou non le changement de mode de fonctionnement.
L'inconvénient de ce circuit est qu'un éventuel fraudeur se rend compte immédiatement que le circuit est protégé, et plus précisément dès qu'il demande un changement de mode. En effet un fraudeur, dont l'objectif est évidemment d'extraire des données du registre de test, se rend immédiatement compte que le registre de test ne contient pas d'information : du fait que les cellules sont initialisées avant le changement de mode effectif, les données susceptibles d'être extraites sont identiques à chaque changement de mode.
Or, l'efficacité d'une mesure de protection d'un circuit électronique se mesure notamment en tenant compte du temps que va mettre un éventuel fraudeur à déterminer qu'une protection existe avant de chercher un moyen de la contourner.

Un objet de l'invention est d'améliorer le circuit électronique de D1. L'invention propose pour cela un circuit électronique protégé mais dont la protection n'est pas détectable immédiatement.

De même qu'un circuit connu, le circuit de l'invention comprend des cellules configurables comprenant chacune une entrée de test et une sortie, les cellules configurables étant susceptibles d'être connectées entre elles en chaîne dans un ordre prédéfini par l'intermédiaire de leur entrée de test et de leur sortie pour former un registre de test si elles reçoivent un signal de commande de chaînage SCAN_ENABLE.

Le circuit selon l'invention est caractérisé en ce qu'il comprend également :
- un circuit de détection, pour produire un signal d'état représentatif d'un état d'initialisation d'un premier ensemble de cellules configurables,
- un circuit de multiplexage, pour relier sélectivement l'entrée de test de chaque cellule configurable d'un deuxième ensemble de cellules configurables soit à la sortie d'une cellule configurable précédente soit à une sortie d'un générateur de données leurres en fonction du signal d'état.

Les données leurres sont des données non pertinentes pour le circuit : les données leurres ne sont pas représentatives des données internes contenues dans le circuit (telles que des données stockées dans les mémoires du circuit) ou produites par le circuit (telles que des données obtenues par combinaison de données internes et de données externes (entrées par un utilisateur autorisé du circuit). Les données leurres ne permettent pas d'obtenir des informations sur des données internes du circuit.

Ainsi, selon l'invention, si les cellules du premier ensemble de cellules configurables ne sont pas dans un état initial, la formation du registre de test est autorisée (activée par le signal de commande de chaînage), mais des données leurres sont propagées dans le registre, au lieu des données contenues dans les cellules non correctement initialisées. Ainsi, un éventuel fraudeur peut extraire des données du registre de test, mais tout ou partie de ces données ne sont pas pertinentes car ce sont des données leurres.

Selon une variante, le générateur de données leurres est un générateur de nombres aléatoires. Selon une autre variante, le générateur de données leurres est adapté pour produire des données leurres en fonction du contenu des cellules configurables, et éventuellement en fonction d'une clé associée par exemple au circuit électronique ou à un utilisateur autorisé du circuit électronique. Le choix du mode de réalisation du générateur de données leurre est fonction de la sécurité que l'on souhaite obtenir pour le circuit.

Le circuit selon l'invention peut également comprendre un circuit de commande tel qu'un contrôleur TAP pour produire les signaux de commande nécessaires à la lecture et à l'écriture dans le registre de test, notamment le signal de commande de chaînage et le signal de propagation de données. Toutefois, ces signaux peuvent également être produits par un contrôleur TAP externe au circuit de l'invention et connecté à une interface d'entrée / sortie du circuit de l'invention.

Si le contrôleur TAP est interne au circuit électronique, on pourra choisir d'inclure ou non le circuit de détection et le générateur de données leurres dans ce contrôleur TAP.

L'invention concerne également une carte à puce comprenant un circuit électronique tel que décrit ci-dessus.

L'invention concerne enfin un procédé de sécurisation d'un circuit électronique tel que décrit ci-dessus. De même qu'un procédé antérieur, le procédé selon l'invention comprend les étapes suivantes :
- une étape de chaînage pour, lorsqu'un signal de commande de chaînage est appliqué sur une entrée de commande de chaînage des cellules configurables, connecter les cellules configurables entre elles dans un ordre prédéfini par l'intermédiaire de leur entrée de test et de leur sortie pour former un registre de test, et
- une étape de propagation de données pour, lorsqu'un signal de commande de propagation de données périodique est appliqué sur une entrée de commande de propagation de données des cellules configurables, entrer et / ou sortir un contenu des cellules configurables,

Le procédé selon l'invention se distingue d'un procédé antérieur en ce qu'il comprend également les étapes suivantes :
- une étape de détection pour produire un signal d'état représentatif d'un état d'initialisation d'un premier ensemble de cellules configurables,
- une étape de commutation, pour relier l'entrée de test de chaque cellule configurable d'un deuxième ensemble de cellules configurables à une sortie d'un générateur de données leurres en fonction du signal d'état.

L'étape de commutation est exécutée en parallèle de l'étape de propagation, pendant une ou plusieurs périodes du signal de propagation de données, puis une nouvelle étape de chaînage est réalisée.

L'invention sera mieux comprise et d'autres caractéristiques et avantages apparaîtront à la lecture de la description qui va suivre, d'exemples de mise en oeuvre d'un circuit électronique selon l'invention. La description, faite à titre indicatif et nullement limitatif, est à lire en relation aux dessins annexés dans lesquels :
- la figure 1 est un schéma d'un premier mode de réalisation d'un circuit selon l'invention,
- la figure 2 est un schéma d'un deuxième mode de réalisation d'un circuit selon l'invention.

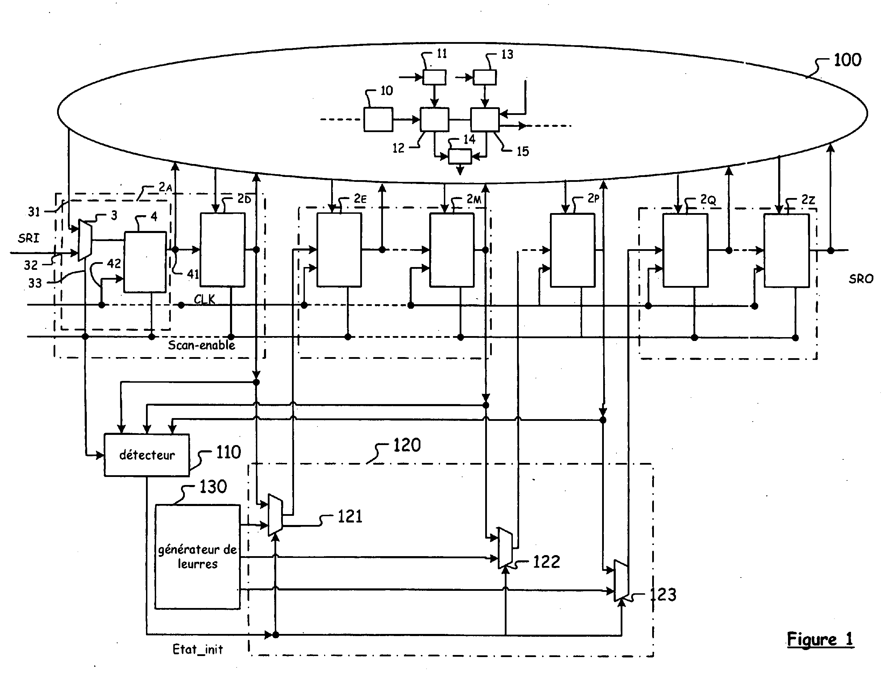

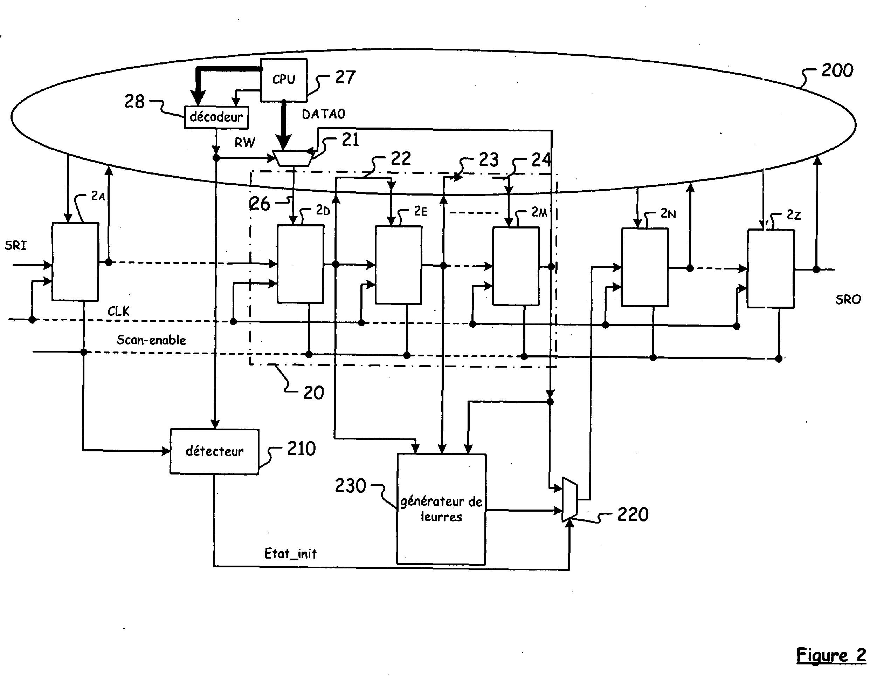

Les figures 1 et 2 illustrent deux exemples d'un circuit électronique selon l'invention.

Le circuit de la figure 1 est un circuit intégré comprenant, de même qu'un circuit antérieur, un circuit de logique 100 comprenant une pluralité de cellules logiques 10 à 15.

Le circuit 1 comprend également des cellules configurables 2a, ..., 2d, 2e, ..., 2m, ..., 2q, ..., 2z, susceptibles d'être connectées aux cellules logiques 10 à 15 pour former au moins un circuit fonctionnel (registre à décalage, machine d'état, etc.), susceptibles d'être connectées entre elles pour former un registre à décalage de test, et susceptibles de recevoir des signaux de commande, notamment un signal de commande de chaînage SCAN_ENABLE et un signal de propagation de données CLK pour inscrire ou lire des données dans les cellules configurables.

Dans l'exemple plus concret de la figure 2, le circuit de logique 200 comprend, notamment, un multiplexeur 21 et des moyens de liaison 22, 23, 24, 25, 26 agencés de sorte que, en mode de fonctionnement standard du circuit électronique, lorsque le signal SCAN_ENABLE est inactif, les cellules configurables 2d, 2e à 2m et le multiplexeur 21 forment un registre interne à décalage 20 comprenant une sortie (constituée par la sortie de la cellule 2m) rebouclé sur une entrée de données (constituée par une première entrée de données du multiplexeur 21). Le circuit 200 comprend également une unité de commande (CPU) 27 et un décodeur d'adresse 28 pour la commande en écriture et en lecture dans le registre interne 20. Le multiplexeur 21 comprend une première entrée connectée à la sortie de la cellule 2m, une deuxième entrée connectée à une sortie de données de l'unité de commande 27, une entrée de commande connectée à une sortie du décodeur d'adresse 28, et une sortie connectée à l'entrée fonctionnelle de la cellule 2d. Le décodeur 28 produit un signal d'écriture (RW actif) ou de lecture (RW inactif) pour la sélection de la première entrée ou de la deuxième entrée du multiplexeur 21. Pour initialiser le registre 20, le décodeur produit un signal RW actif (pour commander une écriture dans le registre) et l'unité de commande 27 applique une donnée initiale DATA0 sur la deuxième entrée du multiplexeur 21. Le registre interne 20 est en pratique un élément du circuit fonctionnel 200, commandable par l'unité de commande 27 et susceptible de contenir des données sensibles.

A noter que le registre à entrée série de la figure 2 n'est qu'un exemple. Le mode de réalisation de l'invention représenté sur la figure 2 peut s'appliquer à tout type de registre, et peut s'appliquer plus généralement à tout premier ensemble de cellules configurables dont les cellules, lorsqu'elles ne reçoivent pas le signal de commande de chaînage SCAN_ENABLE, sont connectées à des cellules logiques avec lesquelles elles coopèrent pour former un circuit logique susceptible être initialisé par l'intermédiaire d'un signal d'initialisation susceptible d'être exploité par le circuit de détection de l'invention, comme on le verra mieux plus loin.

Les cellules configurables sont connues en soi et sont toutes identiques. Aussi, seule la première cellule 2a est détaillée sur la figure 1. Une cellule configurable comprend typiquement :
- une entrée fonctionnelle connectée au circuit logique 100,
- une entrée de test connectée à une sortie d'une cellule précédente, l'entrée de test de la première cellule 2a formant l'entrée SRI du registre de test sur laquelle sont susceptibles d'être appliquées des données à charger dans le registre de test,
- une entrée de commande de chaînage pour recevoir le signal SCAN_ENABLE,
- une entrée de commande de propagation pour recevoir le signal CLK et
- une sortie connectée d'une part au circuit de logique 100 et d'autre part à l'entrée de test d'une cellule configurable suivante, la sortie de la dernière cellule configurable 2z formant la sortie de données SRO du registre de test.
Une cellule configurable comprend typiquement un multiplexeur 3 et une bascule D 4.

Une première entrée 31 du multiplexeur 3 forme l'entrée fonctionnelle de la cellule configurable, et une deuxième entrée 32 du multiplexeur 3 forme l'entrée de test de la cellule configurable. Un plot de sélection 33 du multiplexeur 3 forme l'entrée de commande de chaînage de la cellule configurable et permet de reproduire sélectivement sur la sortie du multiplexeur, soit l'état de sa première entrée soit l'état de sa deuxième entrée. Une sortie du multiplexeur 3 est connectée à une entrée de données de la bascule D 4. Une sortie 41 de la bascule 4 forme la sortie de données de la cellule configurable et est connectée d'une part au circuit de logique 100 et d'autre part à la deuxième entrée 32 du multiplexeur 3 de la cellule configurable suivante, la sortie de donnée 41 de la bascule 4 de la dernière cellule configurable 2z formant quant à elle la sortie SRO du registre de test.

La bascule D présente également une entrée d'horloge 42 formant l'entrée de commande de propagation de la cellule configurable pour recevoir le signal de propagation de données. La bascule D peut éventuellement être commandée en mode de test à une fréquence de test (fréquence du signal CLK) différente de la fréquence de fonctionnement normal du circuit 100.

Selon l'état de la technique, le plot 33 reçoit typiquement un signal de commande de chaînage nommé SCAN_ENABLE fourni de façon connue en soi par un contrôleur TAP (non représenté). Comme décrit dans l'introduction, on réalise un test de chemin interne du circuit logique 100 en appliquant initialement un signal SCAN_ENABLE sur le plot 33 des multiplexeurs. Les cellules configurables sont alors toutes chaînées pour former un registre de test. On charge alors ce registre de test avec les données appliquées à son entrée SRI (qui correspond à la deuxième entrée 32 du multiplexeur de la première cellule configurable 2a), le chargement étant cadencé par le signal de propagation de données CLK. On arrête ensuite l'application du signal SCAN_ENABLE sur le plot 33 pour former un circuit fonctionnel dans lequel les cellules configurables sont connectées aux cellules logiques. Le circuit fonctionnel réalise un ou plusieurs cycles d'horloge avec les données chargées. On applique ensuite de nouveau le signal SCAN_ENABLE pour former le registre de test et on lit alors les données inscrites dans le registre de test sur sa sortie SRO, qui correspond à la sortie de la bascule 4 de la dernière cellule configurable.

L'invention vise notamment à protéger le circuit électronique contre une attaque par microsondage. Une telle attaque peut consister à appliquer une microsonde sur une commande des plots 33 pour former frauduleusement le registre de test et à appliquer une autre microsonde pour inscrire ou lire des données dans ce registre de test.

Selon l'invention, le circuit électronique comprend également un circuit de détection 110, un circuit de multiplexage 120 et un générateur de données leurres 130, pour propager une ou plusieurs données leurres à la place de une ou plusieurs données du registre de test, si certaines au moins des cellules configurables ne sont pas initialisées lors de l'application d'un signal de commande de chaînage actif.

Le circuit de détection a pour fonction de détecter l'état d'un premier ensemble de cellules configurables, et plus précisément de vérifier si les cellules du premier ensemble de cellules sont initialisées ou pas et de produire un signal d'état ETAT_INIT correspondant.

Le premier ensemble de cellules configurables comprend X1 cellules configurables.

Dans un exemple, les X1 cellules sont choisies aléatoirement parmi l'ensemble des cellules configurables. Les cellules 2d, 2m et 2p de la figure 1 ont été ainsi choisies aléatoirement.

Dans un autre exemple, on considère que seulement certaines cellules configurables sont des cellules sensibles, c'est-à-dire susceptibles de contenir des informations confidentielles telles que des clés cryptographiques ou des données personnelles, les autres cellules contenant des données non sensibles telles que des données de commande. On choisit dans ce cas les X1 cellules de préférence parmi les seules cellules configurables sensibles. On peut choisir toutes les cellules sensibles ou seulement certaines. Ainsi, dans l'exemple de la figure 2, on considère que les cellules 2d à 2m, formant un registre interne en mode fonctionnel, sont des cellules sensibles du circuit et que le premier ensemble de cellules comprend les X1 cellules configurables 2d à 2m du registre 20.

Dans l'exemple de la figure 1, le circuit de détection 110 comprend :
- une entrée parallèle sur laquelle sont connectées les sorties de toutes les cellules du premier ensemble de cellules, et
- une sortie sur laquelle est produit le signal ETAT_INIT, actif si l'une au moins des cellules n'est pas dans son état initial.

Le circuit de détection 110 est activé par le signal SCAN_ENABLE. Le circuit de détection (non détaillé sur la figure 1) comprend par exemple un comparateur comprenant une entrée parallèle formant l'entrée du circuit de détection, une entrée de référence sur laquelle est appliquée une valeur de référence représentative de l'état initial de toutes les cellules configurables du premier ensemble de cellules, et une sortie formant la sortie du circuit de détection sur laquelle est produit le résultat de la comparaison.

Dans l'exemple de la figure 2, le circuit de détection 210 comprend :
- une entrée de commande sur laquelle est appliqué le signal d'écriture RW, et
- une sortie sur laquelle est produit le signal ETAT_INIT, actif si le signal d'écriture RW n'a pas été activé depuis une dernière écriture de la donnée initiale DATA0.

Le circuit de détection 210 est activé par le signal SCAN_ENABLE.

Dans un exemple plus général, dans lequel les cellules configurables du premier ensemble de cellules configurables, lorsqu'elles ne reçoivent pas le signal de commande de chaînage SCAN_ENABLE, sont connectées à des cellules logiques avec lesquelles elles coopèrent pour former un circuit logique susceptible être initialisé par l'intermédiaire d'un signal d'initialisation, le circuit de détection est adapté pour produire le signal d'état ETAT_INIT actif si un contenu des cellules configurables du circuit logique n'a pas été modifié depuis une dernière activation du signal d'initialisation.

Le circuit de multiplexage 120 a pour fonction de relier sélectivement l'entrée de test de chaque cellule configurable d'un deuxième ensemble de X2 cellules soit à la sortie d'une cellule configurable précédente soit à la sortie du générateur de données leurres 130, en fonction du signal d'état ETAT_INIT.

Dans l'exemple de la figure 1, le deuxième ensemble de cellules comprend les cellules suivant les cellules du premier ensemble, c'est-à-dire, dans le registre de test, la cellule immédiatement en aval de chaque cellule du premier ensemble, et concrètement dans l'exemple de la figure 1, les cellules 2e, 2n (non représentée) et 2q.

Dans l'exemple de la figure 2, le deuxième ensemble de cellules comprend une seule cellule, et plus précisément la cellule 2n suivant (i.e. située immédiatement en aval de) la dernière cellule 2m formant le registre interne 20.

De tels choix du deuxième ensemble de cellules permettent, lors de la propagation des données dans le registre de test, de remplacer le contenu des cellules du premier ensemble par des données leurres, comme on le verra mieux plus loin.

La réalisation du circuit de multiplexage 120 dépend naturellement du choix des cellules du deuxième ensemble. Le circuit 120 comprend autant de multiplexeurs que le deuxième ensemble comprend de cellules configurables. Chaque multiplexeur comprend une sortie connectée à l'entrée de test d'une cellule du deuxième ensemble de cellule, une première entrée connectée à la sortie de la cellule précédente et une deuxième entrée connectée à une sortie du générateur de données leurres 130.

Ainsi, dans l'exemple de la figure 1, le circuit de multiplexage 120 comprend trois multiplexeurs 121, 122, 123, comprenant chacun une sortie connectée à l'entrée de test d'une cellule du deuxième ensemble de cellule (respectivement les cellules 2e, 2n et 2q), une première entrée connectée à la sortie de la cellule précédente (respectivement les cellules 2d, 2m et 2p) et une deuxième entrée connectée à une sortie du générateur de données leurres 130.

Dans l'exemple de la figure 2, le circuit de multiplexage comprend un unique multiplexeur 220, comprenant une sortie connectée à l'entrée de test de la cellule du deuxième ensemble de cellule (la cellule 2n), une première entrée connectée à la sortie de la cellule précédente (la cellule 2m) et une deuxième entrée connectée à une sortie du générateur de données leurres 130.

Le générateur de données leurres a pour fonction de produire des données susceptibles de remplacer le contenu des cellules configurables et d'induire en erreur un éventuel fraudeur. L'idée de l'invention est ainsi, si les cellules du premier ensemble ne sont pas correctement initialisées, d'autoriser la formation du registre de test (et donc d'autoriser notamment le déchargement de son contenu) mais en remplaçant au moins une donnée des cellules du deuxième ensemble de cellules par une donnée leurre, c'est-à-dire différente du contenu avant initialisation.

Le générateur de données leurres peut comprendre plusieurs sorties pour produire différentes données leurres, et de préférence autant de sorties que le nombre de cellules dans le deuxième ensemble de cellules configurables. C'est ce qui est représenté par exemple sur les figures 1 et 2. Dans une variante (non représentée), le générateur comprend une seule sortie, pour produire une seule donnée leurre appliquée sur les entrées de test de toutes les cellules du deuxième ensemble de cellules par l'intermédiaire du circuit de multiplexage.

Dans un exemple de mise en oeuvre, les données leurres utilisées sont des données constantes, égales au choix à 0 ou 1 logique. Le générateur 130 est réduit dans ce cas à un simple fil de connexion entre une alimentation du circuit et l'entrée du circuit de multiplexage. Ce mode de réalisation n'est toutefois pas très performant : un fraudeur qui demanderait plusieurs fois la formation du registre de test se rendrait en effet rapidement compte que un ou plusieurs bits de données du registre de test sont identiques à chaque exécution, indépendamment des données entrées dans le registre et / ou des instructions exécutées par le circuit fonctionnel.

Dans un autre exemple de mise en en oeuvre, le générateur 130 est un générateur de nombres aléatoires (figure 1).

Ce mode de réalisation est un peu plus efficace que le précédent car les données leurres produites varient à chaque formation du registre de test.

Dans un autre exemple encore, le générateur de données leurre est adapté pour produire des données leurres en fonction du contenu des cellules configurables. L'intérêt d'un tel générateur est qu'il produit des données variables à chaque formation du registre de test, et que ces données sont corrélées avec le contenu réel du registre de test. Selon le mode de réalisation représenté sur la figure 2, un tel générateur 230 (non détaillé) comprend un ensemble de portes logiques (OU, ET, OU-EXCLUSIF, etc.) dont les entrées sont connectées aux sorties des cellules logiques du premier ensemble de cellules logiques. Le générateur produit ainsi sur une sortie une donnée qui est une combinaison logique des données contenues dans les cellules du premier ensemble de cellules configurables. La sortie du générateur est connectée à l'entrée du circuit de multiplexage 220.

Dans un autre exemple encore, le générateur de données leurres est adapté pour produire des données leurres en fonction du contenu des cellules configurables et d'une clé cryptographique, qui peut être par exemple mémorisée dans une mémoire du circuit électronique. Selon un mode de réalisation, un tel générateur peut comprendre un moyen de calcul approprié pour mettre en oeuvre un procédé de hachage, procédé bien connu dans le domaine de la cryptographie pour réaliser le mélange d'une donnée (ici le contenu des cellules du premier ensemble de cellules) et d'une clé cryptographique). La complexité du procédé et du moyen de calcul associé sont généralement fonction de la sécurité attendue d'un tel procédé.

Le procédé de sécurisation de l'invention va maintenant être décrit, dans un exemple de mise en oeuvre dans un circuit selon la figure 1 ou la figure 2.

De même qu'un procédé de sécurisation connu, le procédé selon l'invention comprend les étapes suivantes:
- une étape de chaînage pour, lorsqu'un signal de commande de chaînage SCAN_ENABLE est appliqué sur une entrée de commande de chaînage des cellules configurables, connecter les cellules configurables entre elles dans un ordre prédéfini par l'intermédiaire de leur entrée de test et de leur sortie pour former un registre de test, et
- une étape de propagation de données pour, lorsqu'un signal de commande de propagation de données CLK périodique est appliqué sur une entrée de commande de propagation de données des cellules configurables, sortir un contenu des cellules configurables.

Lorsqu'un passage en mode de test du circuit électronique est demandé par une personne extérieure, le signal SCAN_ENABLE est appliqué sur une entrée de commande de chaînage des cellules pour former le registre de test. Puis le contenu du registre de test est sorti, cadencé par le signal de propagation de données.

Le procédé selon l'invention comprend également les étapes suivantes :
- une étape de détection pour produire un signal d'état ETAT_INIT représentatif d'un état d'initialisation d'un premier ensemble de cellules configurables,
- une étape de commutation, pour relier l'entrée de test de chaque cellule configurable d'un deuxième ensemble de cellules configurables à une sortie d'un générateur de données leurres en fonction du signal d'état.

Ces deux étapes sont réalisées en parallèle de l'étape de propagation de données. Lors de l'étape de détection, on vérifie si les cellules sont correctement initialisées. Puis, si les cellules sont correctement initialisées, le registre de test est formé comme dans les circuits connus. Si au contraire au moins une des cellules du premier ensemble de cellules n'est pas correctement initialisée, alors l'entrée de test de chaque cellule du deuxième ensemble de cellules est connectée à une sortie du générateur de données leurres (et non plus à la sortie de la cellule configurable précédent). Ainsi, le registre de test d'une part n'est pas correctement formé et d'autre part, lors de l'étape de propagation, des données leurres sont insérées dans les cellules du deuxième ensemble de cellules (les cellules 2e, 2m et 2q de la figure 1, la cellule 2n de la figure 2), à la place des données contenues dans les cellules configurables précédentes (les cellules 2d, 2m, 2p de la figure 1, la cellule 2m de la figure 2), qui sont perdues.

Selon une variante, l'étape de commutation est exécutée en parallèle de l'étape de propagation de données, pendant une période du signal de propagation de données CLK, puis une nouvelle étape de chaînage est réalisée. Ainsi, selon cette variante, on propage, dans chaque cellule du deuxième ensemble de cellules et pendant un cycle du signal CLK, une donnée leurre de un bit à la place du contenu de la cellule située immédiatement en amont de chaque cellule du deuxième ensemble de cellules.

Cette variante est par exemple utilisée dans le cadre d'un circuit selon la figure 1, dans lequel les cellules du deuxième ensemble de cellules ne sont pas nécessairement successives ou côte-à-côte dans le registre de test.

Selon une autre variante, l'étape de commutation est exécutée en parallèle de l'étape de propagation de données pendant plusieurs périodes du signal de propagation de données CLK, puis une nouvelle étape de chaînage est réalisée. Ainsi, selon cette variante, on propage, dans chaque cellule du deuxième ensemble de cellules et pendant plusieurs cycles du signal CLK, plusieurs données leurres de un bit à la place du contenu de plusieurs cellules situées immédiatement en amont de chaque cellule du deuxième ensemble de cellules.

Cette variante est par exemple utilisée dans le cadre du circuit de la figure 2, dans lequel plusieurs cellules du deuxième ensemble de cellules sont successives ou côte-à-côte dans le registre de test. Ainsi, avec le circuit de la figure 2, en exécutant l'étape de commutation pendant X2 cycles du signal CLK, on propage dans la cellule 2n X2 données de un bit à la place du contenu des X2 cellules 2d à 2m (le contenu des X2 cellules 2d à 2m étant perdu).

## Revendications

1. Circuit électronique comprenant des cellules configurables comprenant chacune une entrée de test et une sortie, les cellules configurables étant susceptibles d'être connectées entre elles en chaîne dans un ordre prédéfini par l'intermédiaire de leur entrée de test et de leur sortie pour former un registre de test si elles reçoivent un signal de commande de chaînage (SCAN_ENABLE),
le circuit étant **caractérisé en ce qu'**il comprend également :
• un circuit de détection (110), activé par le signal de commande de chaînage (SCAN_ENABLE), pour produire un signal d'état (ETAT_INIT) représentatif d'un état d'initialisation d'un premier ensemble de cellules configurables,
• un circuit de multiplexage (120), pour relier sélectivement l'entrée de test de chaque cellule configurable d'un deuxième ensemble de cellules configurables soit à la sortie de test d'une cellule configurable précédente soit à une sortie d'un générateur de données leurres (130) en fonction du signal d'état.

2. Circuit électronique selon la revendication 1, dans lequel le générateur de données leurres est un générateur de nombres aléatoires.

3. Circuit électronique selon la revendication 1, dans lequel le générateur de données leurres est adapté pour produire des données leurres en fonction du contenu des cellules configurables.

4. Circuit électronique selon la revendication 3, dans lequel le générateur de données leurres est adapté pour produire des données leurres en fonction des données contenues dans les cellules configurables et d'une clé cryptographique.

5. Circuit électronique selon l'une des revendications 1 à 4, dans lequel le circuit de détection est adapté pour produire le signal d'état actif si un contenu des cellules du premier ensemble de cellules est égal à une valeur initiale.

6. Circuit électronique selon l'une des revendications 1 à 4, dans lequel les cellules configurables du premier ensemble de cellules configurables, lorsqu'elles ne reçoivent pas le signal de commande de chaînage (SCAN_ENABLE), sont connectées à des cellules logiques avec lesquelles elles coopèrent pour former un circuit logique susceptible être initialisé par l'intermédiaire d'un signal d'initialisation (RW, DATAO), et dans lequel le circuit de détection est adapté pour produire le signal d'état actif si un contenu des cellules configurables du circuit logique n'a pas été modifié depuis une dernière activation du signal d'initialisation.

7. Circuit électronique selon l'une des revendications 1 à 6, dans lequel le premier ensemble de cellules comprend plusieurs cellules configurables sensibles du circuit intégré.

8. Procédé de sécurisation d'un circuit électronique comprenant des cellules configurables comprenant chacune une entrée de test et une sortie, le procédé comprenant les étapes suivantes :
• une étape de chaînage pour, lorsqu'un signal de commande de chaînage (SCAN_ENABLE) est appliqué sur une entrée de commande de chaînage des cellules configurables, connecter les cellules configurables entre elles dans un ordre prédéfini par l'intermédiaire de leur entrée de test et de leur sortie pour former un registre de test, et
• une étape de propagation de données pour, lorsqu'un signal de commande de propagation de données (CLK) périodique est appliqué sur une entrée de commande de propagation de données des cellules configurables, sortir un contenu des cellules configurables,
le procédé étant **caractérisé en ce qu'**il comprend également les étapes suivantes :
• une étape de détection pour produire un signal d'état (ETAT_INIT) représentatif d'un état d'initialisation d'un premier ensemble de cellules configurables,
• une étape de commutation, pour relier l'entrée de test de chaque cellule configurable d'un deuxième ensemble de cellules configurables à une sortie d'un générateur de données leurres en fonction du signal d'état.

9. Procédé selon la revendication 8, dans lequel l'étape de commutation est exécutée en parallèle de l'étape de propagation de données, pendant une ou plusieurs périodes du signal de propagation de données, une nouvelle étape de chaînage étant réalisée après l'étape de commutation.

10. Carte à puce comprenant un circuit électronique selon l'une des revendications 1 à 7.

## Claims

1. An electronic circuit comprising configurable cells each comprising a test input and an output, the configurable cells being capable of being connected to one another in a chain in a predefined order by means of their test input and their output to form a test register if they receive a chaining command signal (SCAN_ENABLE), the circuit being **characterized in that** it also comprises:
* a detection circuit (110) activated by the chaining command signal (SCAN_ENABLE) to produce a state signal (ETAT-INIT) representing a state of initialization of a first set of configurable cells,
* a multiplexing circuit (120) for the selective connection of the test input of each configurable cell of a second set of configurable cells either to the output of a preceding configurable cell or to an output of a decoy data generator (130) depending on the state signal.

2. An electronic circuit according to claim 1, wherein the decoy data generator is a random number generator

3. An electronic circuit according to claim 1, wherein the decoy data generator is adapted to producing decoy data as a function of the content of the configurable cells.

4. An electronic circuit according to claim 3, wherein the decoy data generator is adapted to producing decoy data as a function of the data contained in the configurable cells and of a cryptographic key.

5. An electronic circuit according to one of the claims 1 to 4, wherein the detection circuit is adapted to producing the active state signal if a content of the cells of the first set of cells is equal to an initial value.

6. An electronic circuit according to one of the claims 1 to 4, wherein the configurable cells of the first set of cells, when they do not receive the chaining command signal (SCAN_ENABLE), are connected to logic cells with which they co-operate to form a logic circuit capable of being reset by means of an initialization signal (RW, DATAO), and wherein the detection circuit is adapted to producing the active state signal if a content of the configurable cells of the logic circuit has not been modified since a last activation of the initialization signal.

7. An electronic circuit according to one of the claims 1 to 6, wherein the first set of cells comprises several sensitive configurables cell of the integrated circuit.

8. A method for securing an electronic circuit comprising configurable cells, each comprising a test input and an output, the method comprising the following steps:
* a chaining step for setting up, when a chaining command signal (SCAN_ENABLE) is applied to a chaining command input of the configurable cells, a connection of these configurable cells to one another in a predefined order by means of their test input and their output to form a test register, and
* a data propagation step for the output, when a periodic data propagation command signal (CLK) is applied to a data propagation command input of the configurable cells, of a content of the configurable cells,
the method being **characterized in that** it also comprises the following steps:
* a detection step for the production of a state signal (ETAT_INIT) representing a state of initialization of a first set of configurable cells,
* a switching step for connecting the test input of each configurable cell of a second set of configurable cells to an output of a decoy data generator as a function of the state signal.

9. A method according to claim 8, wherein the switching step is executed in parallel with the propagation step, during one or more periods of the data propagation signal, a new chaining step being performed after the switching step.

10. Smart card comprising an electronic circuit according to one of the claims 1 to 7.

## Patentansprüche

1. Elektronischer Schaltkreis, umfassend konfigurierbare Zellen mit jeweils einem Testeingang und einem Ausgang, wobei die konfigurierbaren Zellen geeignet sind, mittels ihres Testeingangs und ihres Ausgangs in einer vorgegebenen Ordnung untereinander verkettet zu werden, um ein Testregister zu bilden, wenn sie ein Verkettungs-Befehlssignal (SCAN_ENABLE) empfangen,
wobei der Schaltkreis **dadurch gekennzeichnet ist, dass** er ebenfalls umfasst:
• eine Detektionsschaltung (110), die durch das Verkettungs-Befehlssignal (SCAN_ENABLE) aktiviert wird, um ein Zustandssignal zu erzeugen (ETAT_INIT), das repräsentativ ist für einen Initialisierungszustand einer ersten Gruppe von konfigurierbaren Zellen,
• eine Multiplexschaltung (120), um den Testeingang jeder konfigurierbaren Zelle einer zweiten Gruppe von konfigurierbaren Zellen abhängig von dem Zustandssignal selektiv entweder mit dem Testausgang einer vorhergehenden konfigurierbaren Zelle oder mit dem Ausgang eines Lockdatengenerators (130) zu verbinden.

2. Elektronischer Schaltkreis nach Anspruch 1, wobei der Lockdatengenerator ein Zufallszahlengenerator ist.

3. Elektronischer Schaltkreis nach Anspruch 1, wobei der Lockdatengenerator geeignet ist, Lockdaten in Abhängigkeit des Inhalts der konfigurierbaren Zellen zu erzeugen.

4. Elektronischer Schaltkreis nach Anspruch 3, wobei der Lockdatengenerator geeignet ist, Lockdaten in Abhängigkeit von in den konfigurierbaren Zellen enthaltenen Daten und von einem kryptographischen Schlüssel zu erzeugen.

5. Elektronischer Schaltkreis nach einem der Ansprüche 1 bis 4, wobei die Detektionsschaltung geeignet ist, das aktive Zustandssignal zu erzeugen, wenn ein Inhalt der Zellen der ersten Gruppe von Zellen gleich einem Initialwert entspricht.

6. Elektronischer Schaltkreis nach einem der Ansprüche 1 bis 4, wobei die konfigurierbaren Zellen der ersten Gruppe von konfigurierbaren Zellen, wenn sie das Verkettungs-Befehlssignal (SCAN_ENABLE) nicht empfangen, mit logischen Zellen verbunden werden, mit denen sie kooperieren, um eine logische Schaltung zu bilden, die mittels eines Initialisierungssignals (RW, DATA0) initialisiert werden kann, und wobei die Detektionsschaltung geeignet ist, das Aktivzustandssignal zu erzeugen, wenn ein Inhalt der konfigurierbaren Zellen der logischen Schaltung seit einer letzten Aktivierung des Initialisierungssignals nicht modifiziert worden ist.

7. Elektronischer Schaltkreis nach einem der Ansprüche 1 bis 6, wobei die erste Gruppe von Zellen mehrere konfigurierbare empfindliche Zellen der integrierten Schaltung umfasst.

8. Verfahren zum Sichern eines elektronischen Schaltkreises mit konfigurierbaren Zellen, deren jede einen Testeingang und einen Ausgang aufweist, wobei das Verfahren die folgenden Schritte umfasst:
• einen Verkettungsschritt zur Verbindung der konfigurierbaren Zellen untereinander und in einer vorgegebenen Ordnung mittels ihres Testeingangs und ihres Ausgangs, um ein Testregister zu bilden, wenn ein Verkettungs-Befehlssignal (SCAN_ENABLE) an einem Verkettungsbefehls-Eingang der konfigurierbaren Zellen anliegt, und
• einen Datenübertragungsschritt, um einen Inhalt der konfigurierbaren Zellen auszugeben, wenn ein periodisches Datenübertragungs-Befehlssignal (CLK) an einem Datenübertragungsbefehls-Eingang der konfigurierbaren Zellen anliegt,
wobei das Verfahren **dadurch gekennzeichnet ist, dass** es auch die folgenden Schritte umfasst:
• einen Detektionsschritt zur Erzeugung eines Zustandssignals (ETAT_INIT), das repräsentativ ist für einen Initialisierungszustand einer ersten Gruppe von konfigurierbaren Zellen,
• einen Kommutationsschritt zur Verbindung des Testeingangs jeder konfigurierbaren Zelle einer zweiten Gruppe von konfigurierbaren Zellen mit dem Ausgang eines Lockdatengenerators, abhängig von dem Zustandssignal.

9. Verfahren nach Anspruch 8, wobei der Kommutationsschritt während einer oder mehrerer Perioden des Datenübertragungssignals parallel mit dem Datenübertragungsschritt durchgeführt wird, wobei nach dem Kommutationsschritt ein neuer Verkettungsschritt durchgeführt wird.

10. Chipkarte, umfassend einen elektronischen Schaltkreis nach einem der Ansprüche 1 bis 7.
